# EUROPEAN PATENT APPLICATION

(11) **EP 2 988 394 A1**
(43) Date of publication of application: **24.02.2016**
(21) Application number: 14786079.5
(22) Date of filing: 17.04.2014
(51) Int. Cl.: H02J 13/00, B60L 11/18, H02J 3/32, H02J 7/00

(54) **CONNECTION MONITORING DEVICE AND BATTERY UTILIZATION SYSTEM**

(30) Priority: 19.04.2013 JP 2013088735
(71) Applicant: Panasonic Intellectual Property Management Co., Ltd., Osaka-shi, Osaka 540-6207 (JP)
(72) Inventor: YOSHIZAWA, Jin, Osaka-shi, Osaka 540-6207 (JP)
(74) Representative: Appelt, Christian W.
(86) International application number: PCT/JP2014/002179
(87) International publication number: WO 2014/171145

(57) **Abstract**

A switch (45) exists between first and second terminals (46, 47) provided for the connector (13), and is configured to be in ON when the connector (13) is in connection to the inlet (22), and to be in OFF when the connector is in separation. A first power supply (41) is connected to an electrical circuit including the first and second terminals (46, 47), and configured to supply electrical power during ON period of the switch (45). A judgement circuit (43) is configured to monitor an electrical state of at least one of the first and second terminals (46, 47) and output a monitor signal showing a judgment result of ON or OFF of the switch (45).

## Description

### Technical Field

The invention relates to connection monitoring apparatus configured to monitor whether or not a battery, which an electric drive vehicle is equipped with, is in connection to a distribution grid of an electrical grid, and a battery sharing system configured to share electrical power of the battery.

### Background Art

Electric drive vehicles with a motor as a traveling drive source start to diffuse in recent years. Each electric drive vehicle is equipped with a battery such as a fuel cell or a secondary battery as an energy source. It is therefore suggested that a battery, which an electric drive vehicle is equipped with, be shared as a power production source for a dispersed power source like a photovoltaic cell (see JP Pub. No. 2012-151938, for example).

The electric drive vehicle is equipped with a secondary battery that requires to be charged and is accordingly provided with an inlet. Electrical power to charge the secondary battery is supplied through a connector configured to be connected to and separated from the inlet. The connector is connected to a distribution grid of an electrical grid directly or through a power converter. Electrical power of the secondary battery is therefore provided back to the distribution grid through the connector when the secondary battery is shared as the power production source for the dispersed power source.

For charge of a secondary battery, there is suggested a mechanism configured to start the charge in accordance with a user operation of a start switch after such a connector is connected to an inlet. When remaining capacity of the secondary battery reaches a preset target value, the charge is automatically stopped but the connector is often left connected to the inlet until it is used for a next electric drive vehicle. It is also considered that the start switch is not operated immediately before it is used for the next electric drive vehicle after the connector is connected to the inlet.

When a facility having the connector is configured to provide electrical power of the secondary battery back to a distribution grid of an electrical grid, electrical power of the secondary battery can be provided back to the distribution grid of the electrical grid if the connector is connected to the inlet. In a present state, however, the connector that is in connection to the inlet cannot be recognized from an outside unless charging.

For example, it is assumed that an electric utility makes a request for providing electrical power of the secondary battery back to the distribution grid in order to level electrical energy to be supplied from the electric utility, while a user of the electric drive vehicle has a chance of receiving a value by responding to the request. In this case, the electric utility (or a service provider) cannot grasp that the connector is connected to the inlet, and cannot accordingly make the request for providing the electrical power of the secondary battery back to the distribution grid. The user of the electric drive vehicle is also to lose a chance of obtaining the value.

### Summary of Invention

It is an object of the present invention to provide a connection monitoring apparatus configured to detect whether or not a connector is in connection to an inlet which an electric drive vehicle is equipped with, and to provide a battery sharing system configured to share electrical power of a battery.

One aspect of the invention is connection monitoring apparatus (40) that includes a connector (13), a switch (45), a first power supply (41) and a judgement circuit (43). The connector (13) is configured to be connected to and separated from an inlet (22) provided for an electric drive vehicle (20) equipped with a battery (21), and is configured to be connected to an electrical circuit between the connector (13) and a distribution grid (71) of an electrical grid (70). The switch (45) exists between first and second terminals (46, 47) provided for the connector (13), and is configured to be in ON when the connector (13) is in connection to the inlet (22), and to be in OFF when the connector is in separation from the inlet. The first power supply (41) is connected to an electrical circuit including the first and second terminals (46, 47), and is configured to supply electrical power during ON period of the switch (45). The judgement circuit (43) is configured to monitor an electrical state of at least one of the first and second terminals (46, 47) and to output a monitor signal showing a judgment result of ON or OFF of the switch (45) based on the electrical state.

In an embodiment, the electrical state represents electrical potential (voltage) of at least one of the first and second terminals (46, 47) or an electrical current flowing through at least one of the first and second terminals (46, 47). The judgement circuit (43) is configured, when a value of the electrical potential is a preset standard value or more, or a value of the electrical current is a preset standard value or more, to output a monitor signal showing that the switch (45) is in ON.

In an embodiment, the connection monitoring apparatus (40) further includes a solenoid (14) and a second power supply (42). The solenoid (14) constitutes, between the first and second terminals (46, 47), a series circuit along with the switch (45), and is configured to maintain connection between the connector (13) and the inlet (22). The second power supply (42) is connected to the electrical circuit including the first and second terminals (46, 47), and configured to supply electrical power for drive to the solenoid (14). The first power supply (41) includes a diode (D2) for preventing an electrical current from flowing in from the electrical circuit including the first and second terminals (46, 47).

In an embodiment, the connection monitoring apparatus (40) further includes a communication interface (16) configured to transmit, to an external device (30, 32), the monitor signal that is output from the judgement circuit (43).

One aspect of the invention is a battery sharing system that includes any connection monitoring apparatus (40) described above, a control device (15) and management apparatus (30). The control device (15) is provided for a consumer facility (1) that purchases electricity (electrical power) through the distribution grid (71) of the electrical grid (70), and is configured to control a discharge period and a discharge amount of the battery (21). The management apparatus (30) is configured to receive the monitor signal through the communication interface (16) and to provide, through the communication interface (16), the control device (15) with an instruction to share the battery (21).

In an embodiment of the battery sharing system, the communication interface (16) is provided for a controller (50) configured to perform at least one of control and monitor of equipment (51) in the consumer facility (1).

In an embodiment of the battery sharing system, the battery (21) is a secondary battery. The control device (15) is configured, during ON period of the switch (45) shown by the monitor signal that is output from the judgement circuit (43), to allow the secondary battery (21) to be charged through the connector (13) by electricity (electrical power) from the electrical grid (70), when a voltage value across the voltage lines (72) in the electrical grid (70) exceeds a prescribed value.

In each aspect of the invention, the switch exists between the first and second terminals of the connector and is configured to be in ON when the connector is in connection to the inlet. In addition, the first power supply is connected to the electrical circuit including the first and second terminals. One aspect of the invention includes the judgement circuit configured to monitor an electrical state of at least one of the first and second terminals, thereby outputting a monitor signal showing a judgment result of ON or OFF of the switch.

Whether or not the connector is in connection to the inlet can be therefore detected with the first power supply and the judgement circuit even while electrical power is not supplied between the connector and the inlet. Since the judgement circuit outputs the monitor signal, it is possible to notify an external device whether or not the connector is in connection.

For example, an electric utility or the like can grasp electric drive vehicles capable of power flow back by notification of the monitor signal, which shows that electrical power of the battery is allowed to flow back to the distribution grid of the electrical grid, to the electric utility (or a service provider). On the other hand, users of the electric drive vehicles can increase chances capable of responding to a request for power flow back from the electric utility or the like with connectors connected to inlets.

### Brief Description of Drawings

Preferred embodiments of the invention will now be described in further details. Other features and advantages of the present invention will become better understood with regard to the following detailed description and accompanying drawings where:
FIG. 1A is a block diagram of main parts in accordance with an embodiment and FIG. 1B is another example thereof;
FIG. 2 is a schematic view of an example of the embodiment; and
FIG. 3 is an external view of a configuration example of the embodiment.

### Description of Embodiments

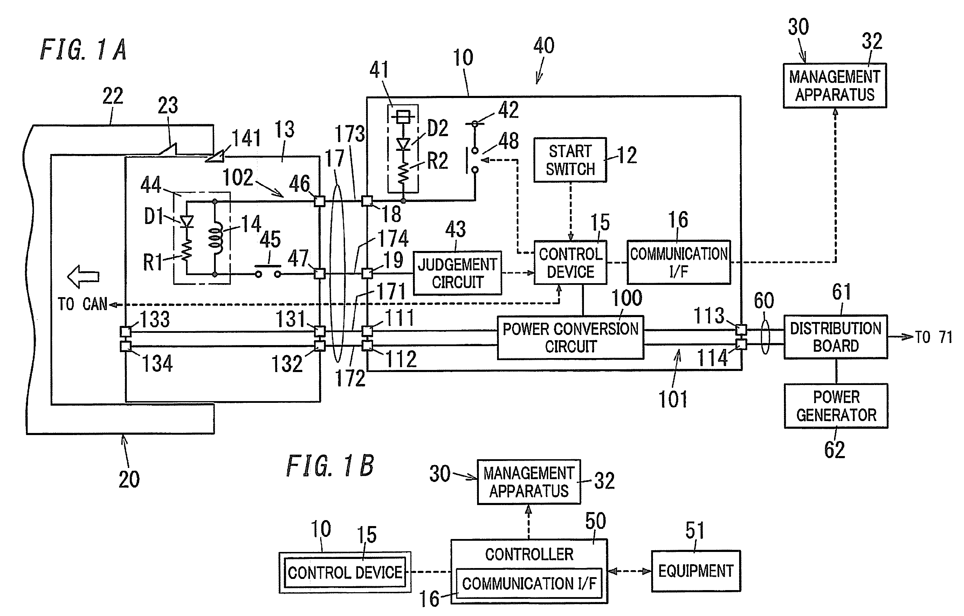

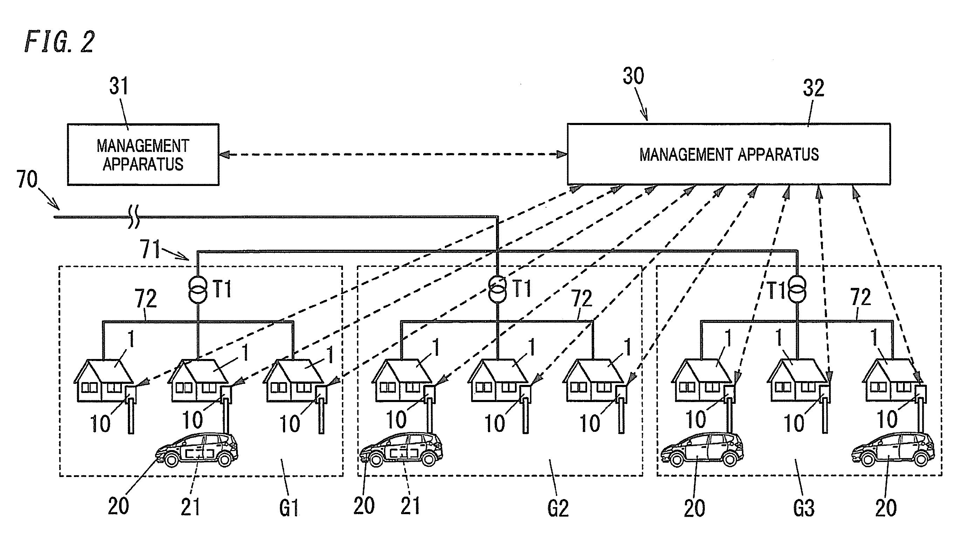

As shown in FIGS. 1A and 2, connection monitoring apparatus 40 according to an embodiment includes a connector 13 that is configured to be connected to and separated from an inlet 22 provided for an electric drive vehicle 20 equipped with a battery 21. The connection monitoring apparatus is configured to be connected to an electrical circuit between the connector 13 and a distribution grid 71 of an electrical grid 70. The connection monitoring apparatus 40 further includes a first power supply 41, a switch 45 and a judgement circuit 43. The switch 45 exists between a first terminal 46 and a second terminal 47, and is configured to be in ON when the connector 13 is in connection to the inlet 22, and also to be in OFF when it is in separation therefrom. The first power supply 41 is connected to an electrical circuit including the first and second terminals 46 and 47 so that it performs an operation for electrical power supply during an ON period of the switch 45. The judgement circuit 43 is configured to monitor an electrical state of at least one of the first and second terminals 46 and 47 to output a monitor signal showing a judgement result on whether the switch 45 is in ON or OFF.

In an example of FIGS. 1A and 2, the connector 13 is electrically connected to the battery 21 through the inlet 22 and also electrically connected to the distribution grid 71 through an electrical circuit 101 including an electric cable 17, a power converter 10 and a distribution board 61. Specifically, the connector 13 includes a first converter-side terminal 131 and a second converter-side terminal 132, and a first battery-side terminal 133 and a second battery-side terminal 134 electrically connected to the first converter-side terminal 131 and the second converter-side terminal 132, respectively. The first and second battery-side terminals 133 and 134 are to be electrically connected to the battery 21. The electric cable 17 includes a first power wire 171 and a second power wire 172 that are electrically connected between the connector 13 and a power conversion circuit 100. The first and second power wires 171 and 172 are electrically connected to the first and second converter-side terminals 131 and 132, respectively. The power converter 10 includes first and second connector-side terminals 111 and 112, first and second board-side terminals 113 and 114, and the power conversion circuit 100. The first and second connector-side terminals 111 and 112 are connected to the first and second power wires 171 and 172, respectively. The first and second board-side terminals 113 and 114 are electrically connected to the distribution board 61 through electric wiring 60. The power conversion circuit 100 is electrically connected between the first and second connector-side terminals 111 and 112 and the first and second board-side terminals 113 and 114.

The first power supply 41 is provided in the power converter 10, and is connected to the electrical circuit 102 that includes the first and second terminals 46 and 47 in the connector 13, the electric cable 17, and the first and second terminals 18 and 19 in the power converter 10. The electric cable 17 further includes a first electric wire 173 and a second electric wire 174. The first electric wire 173 is connected between the first terminal 46 and the first terminal 18, while the second electric wire 174 is connected between the second terminal 47 and the second terminal 19. The judgement circuit 43 is provided in the power converter 10, and electrically connected to the second terminal 19.

Preferably, the connection monitoring apparatus 40 further includes a communication interface 16 that is configured to transmit the monitor signal, which is output from the judgement circuit 43, to an external device. In the example of FIG. 1A, the communication interface 16 is provided in the power converter 10, and configured to transmit the monitor signal to management apparatus 30 as the external device.

It is desirable that the connection monitoring apparatus 40 further include a solenoid (an electromagnetic solenoid) 14 configured to maintain connection between the connector 13 and the inlet 22, and a second power supply 42 configured to supply electrical power for drive to the solenoid 14. The solenoid 14 constitutes, between the first and second terminals 46 and 47, a series circuit along with the switch 45. Preferably, the first power supply 41 includes a diode D2 for preventing an electrical current from flowing in from the electrical circuit 102. In the example of FIG. 1A, the solenoid 14 and the switch 45 are provided in the connector 13, while the second power supply 42 is provided in the power converter 10 and connected to the electrical circuit 102. Specifically, the second power supply 42 is electrically connected, along with the power converter 41, to the first terminal 18 of the power converter 10.

A battery sharing system to be explained below includes any connection monitoring apparatus 40 as stated above, a control device 15 and management apparatus 32. The control device 15 is provided in a consumer facility 1 for purchasing electricity (electrical power) through the distribution grid 71 of the electrical grid 70, and configured to control a discharge period and a discharge amount of the battery 21. In the example of FIG. 1A, the control device 15 is provided in the connection monitoring apparatus 40 (specifically the power converter 10). The management apparatus 32 is configured to receive the monitor signal through the communication interface 16 and to instruct, through the communication interface 16, the control device 15 to share the battery.

As another example, the communication interface 16 may be provided in a controller 50 configured to perform at least one of control and monitor of one or more pieces of equipment 51 in the consumer facility 1, as shown in FIG 1B.

In the following embodiments, electric drive vehicles 20 each of which is equipped with a battery 21 are not limited to a particular kind as long as they fulfill the condition that allows electrical power of the battery 21 to flow back to the distribution grid 71 of the electrical grid 70. That is, each electric drive vehicle 20 can be selected from an electric vehicle, a hybrid vehicle, an electric motorcycle, a fuel cell vehicle and the like. Each electric drive vehicle 20 includes an inlet 22 electrically connected to a battery 21 in order to allow the battery 21 to discharge. The battery 21 allows electrical power to flow back to the distribution grid 71 of the electrical grid 70 through the connector 13 that is configured to be connected to and separated from the inlet 22. It is assumed in the following explanation that a battery 21 which each electric drive vehicle 20 is equipped with is a secondary battery. The inlet 22 is therefore employed not only when the electrical power of the secondary battery 21 is flowed back to a side of the connector 13 but also when the secondary battery 21 is charged.

The power converter 10 is provided in order to allow the electrical power of the secondary battery 21 to flow back to the distribution grid 71 of the electrical grid 70, and configured to convert direct-current power from the secondary battery 21 into alternating-current power equivalent to alternating-current power supplied from the electrical grid 70 to the consumer facility 1. It is desirable that the power converter 10 double as a charger for loading the secondary battery 21 with electricity. That is, the power converter 10 (the power conversion circuit 100) is desirably configured to perform power conversion in two directions between alternating-current and direct-current. The power converter 10 (a power conditioner) forms, along with the secondary battery 21 which the electric drive vehicle 20 is equipped with, a dispersed power source with respect to a system power supply of an electric utility. The electric utility means a provider that obtains values by supplying electrical power, and is not limited to an electric power company.

It is assumed that each consumer facility 1 is a detached house with a parking space. However, technology in the embodiment can be applied to even a condominium with parking if connectors 13 are provided for. The technology in the embodiment can be also applied to even parking provided for a facility such as a commercial facility, an industrial facility or an airport if connectors 13 to be connected to individual electric drive vehicles 20 are provided for.

In the example of FIG. 2, each of consumer facilities 1 has a power converter 10 arranged therein. The power converter 10 has a function configured to convert direct-current power, of a secondary battery 21 which an electric drive vehicle 20 is equipped with, into alternating-current power corresponding to that of the electrical grid 70. The consumer facilities 1 are also divided up into groups G1 to G3. For example, each of the groups G1 to G3 includes consumer facilities 1 that receive electrical power from a secondary side of a step-down transformer (a pole-mount transformer or the like) T1. However, each of the groups G1 to G3 may include consumer facilities 1 that receive electrical power from secondary sides of two or more step-down transformers T1. For example, each of the groups G1 to G3 may include, as one unit, one of regions which the electric utility divides the distribution grid into.

In the configuration example shown in FIG. 2, a power converter 10 installed in each of the consumer facilities 1 has a communication function (a communication interface 16) and is configured to communicate with the management apparatus 30 as host apparatus. In the depicted example, the host apparatus 30 includes first and second management apparatus 31 and 32. The electric utility manages the first management apparatus 31. The second management apparatus 32 is managed by a service provider as an intermediary between the electric utility and the consumer facilities 1. The service provider has a role of adjusting, after reception of a request from one of the electric utility and a consumer facility 1, reception of the request by the other so that it becomes easy. This sort of service provider is called energy aggregator.

It is assumed that time periods of maximum electrical energy to be consumed by the consumer facilities 1 overlap each other. In this case, a margin of electrical energy to be supplied from the electric utility decreases with respect to total amount of electrical energy to be assumed by consumer facilities 1 of each group in the time periods. In some cases, there is also a possibility that electrical energy to be supplied from the electric utility can supply is below electrical energy to be demanded by the consumer facilities 1.

When it is expected that such an event described above will occur, the second management apparatus 32 obtains, from the first management apparatus 31, electrical energy that the electric utility can supply or a power saving rate that the electric utility requires, and provides the power converters 10 installed in the consumer facilities 1 with instructions to share respective electrical power of the storage batteries 21.

In this instance, the service provider (the second management apparatus 32) is to substantially receive, from the electric utility (the first management apparatus 31), a request for power flow back. Each consumer facility 1 substantially allows electrical power to flow back to the electric utility when receiving an instruction from the service provider (the second management apparatus 32) to operate its own power converter 10 so that electrical power of a corresponding battery 21 is allowed to flow back to the distribution grid 71 of the electrical grid 70.

In short, from a service provider's point of view, respective electrical power received from the consumer facilities 1 are to be flowed back in response to the request, from the electric utility, for power flow back. It is therefore reasonable that the service provider provides consumer facilities 1, from which respective electrical power is flowed back, with respective values in response to electrical energy flowed back therefrom, and receives values corresponding to respective electrical energy from the electric utility that made the request for power flow back.

It can be considered that each consumer facility 1 would substantially provide electrical power back to the distribution grid 71 of the electrical grid 70 even if sharing electrical power of the secondary battery 21 in the consumer facility 1 without allowing electrical power of the secondary battery 21 to flow back to the distribution grid 71 of the electrical grid 70 beyond a boundary of responsibility. Therefore, when the service provider is the intermediary between the electric utility and the consumer facilities 1, the consumer facilities 1 can receive values in response to respective electrical energy provided back from the storage batteries 1.

When the service provider exists as the intermediary between the electric utility and the consumer facilities 1 as stated above, any consumer facility 1 loses a chance to receive the value if it has not notified the management apparatus 32 that it is waiting in a state to enable electrical power from the secondary battery 21 thereof to flow back. In order to avoid losing the chance, any consumer facility 1 needs to notify the management apparatus 32 that the power converter 10 and the secondary battery 21 of the electric drive vehicle 20 are electrically connected with each other before the electric utility makes a request for power back flow.

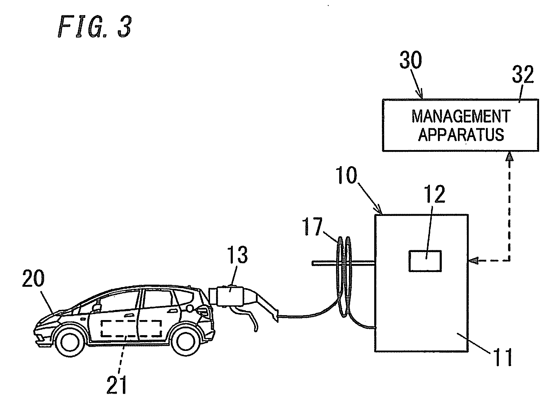

Each consumer facility 1 is generally provided with a power converter 10 of stand type, or case type configured to be attached on a wall surface of a building. The stand or the case includes a start switch 12 to be operated when the secondary battery 21 is ready to charge and discharge. FIG. 3 shows an external view of a configuration in which a case 11 of the power converter 10 is provided with the start switch 12. The electric drive vehicle 20 includes the inlet 22 (see FIG. 1A), and the electric cable 17 is pulled out from the case 11 and forms the electrical circuit between the connector 13 to be connected to the inlet 22, and the power converter 10.

The inlet 22 includes a recess (not shown) which part of the connector 13 is to be inserted into, and electrodes in the recess. In the embodiment, the inlet 22 and the connector 13 is a type of CHAdeMO (trademark). That is, the inlet 22 includes electrodes electrically connected to the secondary battery 21 and signal electrodes for CAN (Controller Area Network). The electric cable 17 includes electric wires for CAN. However, the specifications of the inlet 22 and the connector 13 are not limited to the CHAdeMO.

The connector 13 is configured to be inserted into the inlet 22 to be in connection and to be separated from the inlet 22 to be in separation. The connector 13 is also provided with a falling prevention claw 141 configured to protrude from and retract into lateral part of the connector 13 in order to prevent the connector 13 from falling out from the inlet 22 to keep the connection. The inlet 22 is provided in a lateral face inside the recess with a receiving part 23 configured to engage with the falling prevention claw 141 protruded from the lateral part of the connector 13.

As shown in FIG. 1A, the connector 13 includes the solenoid 14 in order to maintain, in connection (in an ON state of the switch 45), a state where the falling prevention claw 141 protruding from the lateral part of the connector 13 is engaged with the receiving part 23. The solenoid 14 is configured so that while a coil of the solenoid 14 is energized, a plunger (not shown) of the solenoid 14 prohibits the falling prevention claw 141 from moving so that it maintains the state where the falling prevention claw 141 protruding from the lateral part of the connector 13 is engaged with the receiving part 23. The solenoid 14 is also configured, while the coil of the solenoid 14 is not energized, to release the plunger from prohibiting the movement of the falling prevention claw 141, thereby allowing the falling prevention claw 141 to protrude from and retract into the lateral part of the connector 13.

The power converter 10 and the connector 13 not only are configured to adjust electrical power to allow the secondary battery 21 to charge and discharge, but also form the connection monitoring apparatus 40 configured to monitor whether or not the connector 13 is in connection to the inlet 22.

The connection monitoring apparatus 40 has a function configured to judge whether or not the connector 13 is in connection to the inlet 22, and to output a monitor signal showing a judgment result. As shown in FIG. 1A, the connection monitoring apparatus 40 includes the first power supply 41 and the judgement circuit 43 that are added to the power conversion circuit 10, and an energizing circuit 44 and the switch 45 that are added to the connector 13.

The energizing circuit 44 is connected in series with the switch 45, and a series circuit of the energizing circuit 44 and the switch 45 is connected between the first and second terminals 46 and 47 provided in the connector 13. Specifically, a first end and a second end of the energizing circuit 44 are connected to the first terminal 46 and a first end of the switch 45, respectively, and a second end of the switch 45 is connected to the second terminal 47. The energizing circuit 44 has a configuration where the solenoid 14 (the coil) described above is connected in parallel with a series circuit of a diode D1 and a resistor R1. The series circuit of the diode D1 and the resistor R1 is provided in order to suppress noise produced by the solenoid 14.

The switch 45 is configured to work in tandem with the falling prevention claw 141 configured to protrude from and retract into the lateral part of the connector 13. The switch 45 is in ON when the connector 13 is in connection to the inlet 22, namely in the state where the falling prevention claw 141 protruding from the lateral part of the connector 13 is engaged with the receiving part 23. The switch 45 is also in OFF when the connector 13 is in separation from the inlet 22. When the connector 13 is in the separation, the falling prevention claw 141 is allowed to retract into the lateral part of the connector 13. The connector 13 produced to CHAdeMO specifications is provided as standard with the switch 45 configured to work in tandem with the falling prevention claw 141. Similarly, the connector 13 is also provided as standard with the energizing circuit 44.

The first terminal 46 of the connector 13 is connected to the first power supply 41 and to the second power supply 42 for driving the solenoid 14 through a switch 48. The second terminal 47 of the connector 13 is connected to an input end of the judgement circuit 43. The first and second power supplies 41 and 42 are connected to the electrical circuit 102. Each of the first and second power supplies 41 and 42 is a direct-current power supply. In the depicted example, the first terminal 46 (the first terminal 18) is connected to positive electrodes of the first and second power supplies 41 and 42.

In short, when the switches 45 and 48 are in ON and OFF, respectively, only the first power supply 41 causes an electrical current to flow through the energizing circuit 44. When both the switches 45 and 48 are in ON, the first and second power supplies 41 and 42 cause respective electrical currents to flow through the energizing circuit 44. The switch 45 turns on and off in tandem with the falling prevention claw 141, while the switch 48 turns on and off in accordance with an instruction from the control device 15. The first power supply 41 is configured to output an electrical current so that even it flows through the solenoid 14, the solenoid 14 is not driven (an electrical current smaller than an electrical current for driving the solenoid). The second power supply 42 is configured to output a comparatively large electrical current for driving the solenoid 14 (an electrical current for driving the solenoid).

The control device 15 includes, as a main hardware configuration, a device including a processor configured to operate in accordance with a program(s). Examples of this sort of device include a microcomputer that integrally includes a processor and a memory, a microprocessor which another memory is added to, and the like. The program is installed in advance before delivery of a product thereof, but can be installed as an update program such as firmware through an electrical communications network such as the Internet or from a storage medium.

The judgement circuit 43 is configured: to detect electric potential (a voltage) at the second terminal 47 (the second terminal 19) or an electrical current flowing through the second terminal 47; to judge that the switch 45 is in ON when the detected electrical state (the electric potential or the electrical current) is a preset reference value or more; and to output a monitor signal showing that the switch 45 is in ON. Specifically, when the switch 45 is in ON and the first power supply 41 allows an electrical current to flow through the energizing circuit 44, the judgement circuit 43 outputs the monitor signal showing that the switch 45 is in ON, regardless of whether the switch 48 is in ON or OFF. That is, in the case of detecting an electrical current flowing through the second terminal 47, the judgement circuit 43 outputs the monitor signal showing that the switch 45 is in ON when a value of the electrical current flowing through the second terminal 47 is a reference value or more. On the other hand, in the case of detecting the electric potential at the second terminal 47, the judgement circuit 43 which is formed of, e.g., a comparator outputs the monitor signal showing that the switch 45 is in ON when a value of the electric potential at the second terminal 47 is a reference value or more.

The first terminal 46 of the connector 13 is connected to the first power supply 41 and to the second power supply 42 through the switch 48, and further connected to the energizing circuit 44 including the solenoid 14. There is therefore a possibility that an electrical current flows in a reverse direction from the first terminal 46 in response to ON or OFF of the switch 48. The first power supply 41 includes the diode D2 for preventing an electrical current from flowing in from the electrical circuit 012. A cathode of the diode D2 is connected to the first terminal 46 (the first terminal 18) through a resistor R2.

In the depicted configuration, the control device 15 is configured to communicate with the external device through the communication interface (hereinafter called a "communication I/F") 16. The control device 15 receives the monitor signal that is output from the judgement circuit 43, and transmits the signal to the external device through the communication I/F 16. The communication I/F 16 is configured to communicate with the second management apparatus 32 stated above.

Therefore, data corresponding to the monitor signal showing that the switch 45 is in ON are transmitted to the second management apparatus 32 through the communication I/F 16, and accordingly the second management apparatus 32 can recognize that the connector 13 is connected to the electric drive vehicle 20. That is, even if the start switch 12 is not operated, the second management apparatus 32 recognizes that when the connector 13 is in connection to the inlet 22 and the secondary battery 21 is in electrical connection to the terminals of the connector 13, electrical power of the secondary battery 21 is enabled to flow back to the distribution grid 71. In this state, when receiving a request, from the first management apparatus 31, for power flow back, the second management apparatus 32 transmits, to control devices 15 that enable electrical power of respective secondary batteries 21 to flow back, requests for power back flow so as to secure necessary electrical energy.

If the connector 13 is merely in connection to the inlet 22, the solenoid 14 is energized only by output of the first power supply 41, and accordingly the solenoid 14 is not driven. The start switch 12 is operated in order to drive the solenoid 14, thereby causing the control device 15 to output an instruction to turn on the switch 48. When the start switch 12 is operated and the switch 48 is turned on, the second power supply 42 energizes the solenoid 14, and the solenoid 14 prohibits the falling prevention claw 141 from moving. In this state, even if a comparatively large force is exerted on the connector 13, the connector 13 can be prevented from falling out from the inlet 22.

In an embodiment, the control device 15 is provided with the controller 50 on a communication path between the control device and the management apparatus 32 (see FIG. 1B). The controller is configured to perform at least one of control and monitor of the equipment 51 in the consumer facility 1. This sort of controller 50 is called a HEMS (Home Energy Management System) controller, and has a function configured to obtain information on an operation of the equipment 51 to control the operation of the equipment 51 so that energy consumption thereof is reduced, for example. In an example, the communication between the control device 15 and the controller 50 is carried out through respective wireless or cable communication devices (not shown). For example, if a communication device of the control device 15 is a device corresponding to a communication I/F 16 of the controller 50, the controller 50 does not need including another communication device for communicating with the control device 15.

In the case where the controller 50 is connected to the electrical communications network such as the Internet, desirably communication between each connection monitoring apparatus 40 and the management apparatus 32 is made through the controller 50. In other words, a dispersed power source as a combination of the electric drive vehicle 20 and the connection monitoring apparatus 40 (the power converter 10) is regarded as a piece of equipment in the consumer facility 1 and the controller 50 manages the dispersed power source like other equipment 51. In this instance, the controller 50 is connected to the electrical communications network through a communication I/F, and is to communicate with the management apparatus 32 through the communication I/F.

The control device 15 has not only the function configured to notify the management apparatus 32 that the connector 13 is in connection to or separation from the inlet 22, but also a function configured to monitor a state of the secondary battery 21 when the connector 13 is in connection to the inlet 22. That is, the control device 15 has a function configured to manage information, such as a charge amount, a discharge amount, a remaining amount and a degradation level, of the secondary battery 21. For example, after notifying the management apparatus 32 that the connector 13 is in the connection, the control device 15 controls a discharge period and the discharge amount of the secondary battery 21 based on the remaining amount of the secondary battery 21, electrical energy required for driving the electric drive vehicle and the like if receiving a request, from the management apparatus 32, for power flow back.

As is obvious from the configuration stated above, the technology of the embodiment can be applied to a configuration where a fuel cell is replaced with the secondary battery 21. In this instance, the management apparatus 32 doesn't need to ask whether the battery which the electric drive vehicle 20 is equipped with is enabled to charge because it can provide the consumer facility 1 with a request for power flow back after the consumer facility notifies the management apparatus 32 that the connector 13 is in connection to the inlet 22.

An operation example of the aforementioned configuration will be explained.
(1) In a case where the connector 13 is in separation from the inlet 22, the electric drive vehicle 20 is in use or the connector 13 is in disconnection. It is therefore impossible to allow electrical power of the secondary battery 21 to flow back to the distribution grid 71. In this instance, the second management apparatus 32 cannot provide a corresponding consumer facility 1 with a request for power flow back to the distribution grid 71, and accordingly notifies the control device 15 (or the controller 50) of the presence of the request for power flow back to cause an indication device (not shown) capable of communicating with the control device 15 (or the controller 50) to indicate it. This sort of indication device may be not only a dedicated device added to the control device 15 (or the controller 50) but also a general purpose device such as a smart phone or a tablet terminator.
(2) In a case where the connector 13 is in connection to the inlet 22 and the start switch 12 is not operated, the switch 45 that works in tandem with the falling prevention claw 141 is in ON, and accordingly the judgement circuit 43 outputs a monitor signal corresponding to ON of the switch 45. Information corresponding to the monitor signal is notified to the second management apparatus 32, so that the second management apparatus 32 is notified that the secondary battery 21 is connected to the power converter 10. The second management apparatus 32 can consequently provide the corresponding consumer facility 1 with a request for power flow back.
(3) In a case where the connector 13 is in connection to the inlet 22 and the start switch 12 is operated, the control device 15 carries out communication through the CAN of the electric drive vehicle 20. After the power converter 10 and the electric drive vehicle 20 check different items, the control device 15 indicates an instruction to turn on the switch 48 to drive the solenoid 14. Even when the switch 48 is turned on, the judgement circuit 43 outputs a monitor signal to notify the second management apparatus 32 that the secondary battery 21 is connected to the power converter 10. The second management apparatus 32 can consequently provide the corresponding consumer facility 1 with a request for power flow back.

As stated above, the second management apparatus 32 can take the number of the electric drive vehicles 20 in connection every group, and is accordingly easy to estimate electrical energy corresponding to a request for power flow back, from the first management apparatus 31. The second management apparatus 32 can provide consumer facilities 1 with requests for power flow back to the distribution grid 71 from secondary batteries 21 which electric respective drive vehicles 20 are equipped with.

The aforementioned configuration is a simple configuration obtained by just adding, to an ordinary configuration, the first power supply 41 and the judgement circuit 43 compliant with the first power supply 41. Accordingly, an increase in cost can be suppressed.

The aforementioned explanation was about a case of sharing electrical power discharged from (the fuel cells or) the storage batteries 21 which the electric drive vehicles 20 are equipped with, but in a case of the storage batteries 21 which the electric drive vehicles 20 are equipped with, the storage batteries 21 can be also charged.

As shown in the example of FIGS. 1A and 2, in a case where a renewable energy type power generator 62 such as a Photovoltaic system or a wind turbine generator is connected to the electrical grid 70 through the distribution board 61 so as to permit power flow back, there is a possibility that a voltage value across voltage lines 72 in the electrical grid 70 increases when an amount of power generated by the power generator 62 increases. In the present circumstances, when a voltage value across the voltage lines 72 in the electrical grid 70 considerably increases, the power generator 62 suppresses the amount of power generated and a rise in the voltage value. Therefore, this results in a loss of income opportunity by selling electricity of the power generator 62.

The control device 15 according to the embodiment has a function configured, when a voltage value across the voltage lines 72 in the electrical grid 70 exceeds a prescribed value, to control the power converter 10 so that the secondary battery 21 is charged by electrical power from the electrical grid 70. The function allows the secondary battery 21 of the electric drive vehicle 20 to charge by surplus power of the power generator 62 when the voltage value across the voltage lines 72 in the electrical grid 70 is increasing, thereby suppressing a rise in the voltage value.

The control device 15 can provide an instruction to charge the secondary battery 21 when the aforementioned conditions are satisfied in a case where renewable energy type power generators 62 are provided in a region forming the groups G1 to G3 and electric drive vehicles 20 exist therein. That is, it is possible to reduce a possibility of a loss of income opportunity by selling electricity as a result of managing each power generator 62.

Even in the case where the secondary battery 21 is charged like this, it is necessary to recognize that the connector 13 is in connection to the inlet 22. The control device 15 therefore performs the aforementioned operations during ON time of the switch 45 according to the monitor signal from the judgement circuit 43.

## Claims

1. Connection monitoring apparatus, comprising:
a connector configured to be connected to and separated from an inlet provided for an electric drive vehicle equipped with a battery, the connector being configured to be connected to an electrical circuit between the connector and a distribution grid of an electrical grid;
a switch that exists between first and second terminals provided for the connector, the switch being configured to be in ON when the connector is in connection to the inlet, and to be in OFF when the connector is in separation from the inlet;
a first power supply that is connected to an electrical circuit including the first and second terminals, the first power supply being configured to supply electrical power during ON period of the switch; and
a judgement circuit configured to monitor an electrical state of at least one of the first and second terminals and to output a monitor signal showing a judgment result of ON or OFF of the switch based on the electrical state.

2. The connection monitoring apparatus of claim 1, wherein
the electrical state represents electrical potential of at least one of the first and second terminals or an electrical current flowing through at least one of the first and second terminals, and
the judgement circuit is configured, when a value of the electrical potential is a preset standard value or more, or a value of the electrical current is a preset standard value or more, to output a monitor signal showing that the switch is in ON.

3. The connection monitoring apparatus of claim 1 or 2, further comprising
a solenoid that constitutes, between the first and second terminals, a series circuit along with the switch, the solenoid being configured to maintain connection between the connector and the inlet, and
a second power supply that is connected to the electrical circuit including the first and second terminals, and configured to supply electrical power for drive to the solenoid, wherein
the first power supply comprises a diode for preventing an electrical current from flowing in from the electrical circuit including the first and second terminals.

4. The connection monitoring apparatus of any one of claims 1 to 3, further comprising a communication interface configured to transmit, to an external device, the monitor signal that is output from the judgement circuit.

5. A battery sharing system, comprising:
the connection monitoring apparatus of claim 4;
a control device provided for a consumer facility that purchases electricity through the distribution grid of the electrical grid, the control device being configured to control a discharge period and a discharge amount of the battery; and
management apparatus configured to receive the monitor signal through the communication interface and to provide, through the communication interface, the control device with an instruction to share the battery.

6. The battery sharing system of claim 5, wherein the communication interface is provided for a controller configured to perform at least one of control and monitor of equipment in the consumer facility.

7. The battery sharing system of claim 5 or 6, wherein
the battery is a secondary battery, and
the control device is configured, during ON period of the switch shown by the monitor signal that is output from the judgement circuit, to allow the secondary battery to be charged through the connector by electricity from the electrical grid, when a voltage value across voltage lines in the electrical grid exceeds a prescribed value.
